# EUROPEAN PATENT APPLICATION

(11) **EP 2 028 512 A2**
(43) Date of publication of application: **25.02.2009**
(21) Application number: 08013508.0
(22) Date of filing: 26.07.2008
(51) Int. Cl.: G02B 6/42, H01S 5/022, H01S 5/40, H01S 5/0683, H04B 10/04, H04B 10/24, H01L 33/00

(54) **Optical communication device**

(30) Priority: 01.08.2007 TW 96128245
(71) Applicant: AmTRAN Technology Co. Ltd., Taipei County 235 Taiwan (TW)
(72) Inventor: Wen-Ping, Yu, Taiwan (TW)
(74) Representative: Becker, Bernd

(57) **Abstract**

The present invention provides an optical communication device, which includes a base (30), an optical fiber module (32), a first submount (34), a second submount (36), a first light emitter (38), and a second light emitter (40). The base thereon defines a first reference axis (300) and has a receptacle portion formed at the first reference axis. The optical fiber module is mounted in the receptacle portion and includes an optical fiber. The first submount and the second submount are mounted on the base at the first reference axis. The first light emitter is mounted on the first submount and optically coupled to the optical fiber. The second light emitter is mounted on the second submount and optically coupled to the optical fiber. The first submount (34) is disposed between the second submount (36) and the optical fiber module (32) and is adjacent to the second submount (36). The height of the second submount (36) is higher than that of the first submount (34).

## Description

### BACKGROUND OF THE INVENTION

### 1. Field of the invention

This present invention relates to an optical communication device, and more particularly, to an optical communication device which uses stacked structures to allow two light emitters to transmit data over an optical fiber simultaneously.

### 2. Description of the prior art

It is a known practice to transmit data between two communication units asymmetrically, i.e. to produce different data rates in two transmission directions. This is particularly appropriate when the data rates or bandwidths in the two transmission directions differ greatly. To produce asymmetrical links, it is a known practice to connect two communication units via a fiber-optic link. The fiber-optic link has either two fibers, one for each respective transmission direction, or one fiber only, through which case data are transmitted in a half-duplex mode or simultaneously (if different wavelengths are used).

Moreover, it is inefficient that an asymmetrical data transmission requires only a high bandwidth for one transmission direction in prior arts. For example, a link between a camera, a control unit and a screen requires a high bandwidth in the Gigabit/s range only for transmitting data from the camera to the screen. By contrast, the control signals for the camera which are transmitted in the opposite direction by the control unit generally require only a low bandwidth in the K-bit/s range.

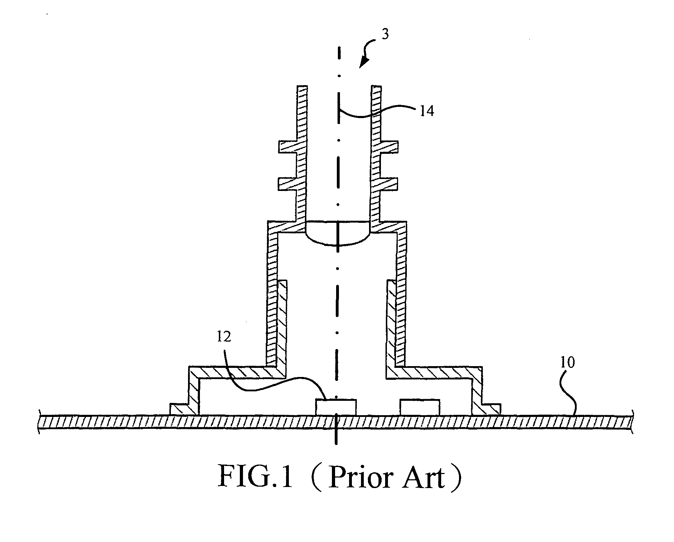

Please refer to FIG. 1. FIG. 1 is a cross-sectional view illustrating an optical communication device of a prior art. As shown in FIG. 1, a light emitter 12 is mounted on a base 10, and the optical communication has a light axis 14 perpendiculars to the base 10. The light emitter 12 emits light along the light axis 14. That is, the light emitter 12 is a surface-emitting laser diode.

However, when the data require to be transmitted become larger, it will be insufficient to transmit the data only by one light emitter. Under such a circumstance, it is necessary to consider transmitting the data over the optical fiber by using more than two light emitters with different wavelengths. But the package structure of a surface light emitter cannot be easily achieved.

Accordingly, an object of the invention is to provide an optical communication device, through whose structure more than two light emitters are capable of transmitting data over one optical fiber simultaneously.

### SUMMARY OF THE INVENTION

The optical communication device, according to a preferred embodiment of the invention, includes a base, an optical fiber module, a first submount, a second submount, a first light emitter, and a second light emitter. The base thereon defines a reference axis and has a receptacle portion formed and at the first reference axis. The optical fiber module is mounted in the receptacle portion. The optical fiber module comes with an optical fiber. The first submount is mounted on the base and at the first reference axis. The second submount is mounted on the base and at the first reference axis, and wherein the first submount is disposed between the second submount and the optical fiber module, and is adjacent to the second submount. The height of the second submount is higher than that of the first submount. The first light emitter is mounted on the first submount and optically coupled to the optical fiber. The first light emitter is for generating, by driven, a first forward light signal into a facet of the optical fiber, and the first forward light signal is then transmitted over the optical fiber. The second light emitter is mounted on the second submount and optically coupled to the optical fiber. The second light emitter is for generating, by driven, a second forward light signal into a facet of the optical fiber, and the second forward light signal is then transmitted over the optical fiber, too.

Accordingly, the optical communication device according to the invention is able to allow two light emitters to transmit data over an optical fiber simultaneously, so as to increase the data rates. Furthermore, the optical communication device of the invention can be used in a bidirectional symmetrical transmit mode or in a bidirectional asymmetrical mode because of the quantity of adopted light emitters.

The advantage and spirit of the invention may be understood by the following recitations together with the appended drawings.

### BRIEF DESCRIPTION OF THE APPENDED DRAWINGS

FIG. 1 is a cross-sectional view illustrating an optical communication device of a prior art.
FIG. 2 is a schematic diagram illustrating an optical communication device according to a preferred embodiment of the invention.
FIG. 3A is a top view illustrating the relative positions of a first light emitter and a second light emitter in FIG. 2.
FIG. 3B is a side view of FIG. 3A.

### DETAILED DESCRIPTION OF THE INVENTION

An objective of the invention is to provide an optical communication device. The optical communication device of the invention allows two light emitters to transmit data over one optical fiber simultaneously. The spirit and feature of the present invention will be described in detail by the following preferred embodiments.

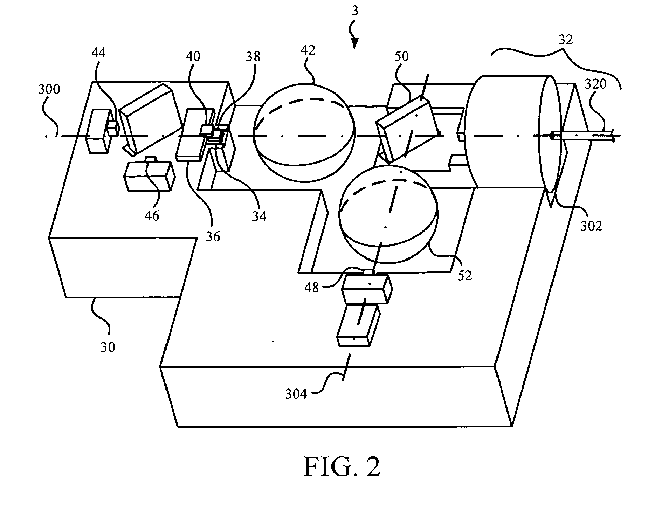

Please refer to FIG. 2. FIG. 2 is a schematic diagram illustrating an optical communication device 3 according to a preferred embodiment of the invention. As shown in FIG. 2, the optical communication device 3 includes a base 30, an optical fiber module 32, a first submount 34, a second submount 36, a first light emitter 38, and a second light emitter 40.

As shown in FIG. 2, the base 30 thereon defines a first reference axis 300 and has a receptacle portion 302 formed at the first reference axis 300. The optical fiber module 32 is mounted in the receptacle portion 302. The optical fiber module 32 includes an optical fiber 320.

Moreover, the first submount 34 is mounted on the base 30 and at the first reference axis 300. The second submount 36 is mounted on the base 30 and at the first reference axis 300, wherein the first submount 34 is disposed between the second submount 36 and the optical fiber module 32 and is adjacent to the second submount 36. The height of the second submount 36 is higher than that of the first submount 34.

Also shown in FIG. 2, the first light emitter 38 is mounted on the first submount 34 and is optically coupled to the optical fiber 320. The first light emitter 38 is for generating, by driven, a first forward light signal into a facet of the optical fiber 320. The first forward light signal is then transmitted over the optical fiber 320.

Similarly, the second light emitter 40 is mounted on the second submount 36 and is optically coupled to the optical fiber 320. The second light emitter 40 is for generating, by driven, a second forward light signal into the facet of the optical fiber 320. The second forward light signal is then transmitted over the optical fiber 320.

In an embodiment, the optical communication device 3, according to the invention, further includes a first lens module 42. The first lens module 42 is mounted on the base 30 and at the first reference axis 300. The first lens module 42 is disposed between the first submount 34 and the optical fiber module 32, wherein the first forward light signal and the second forward light signal are focused by the first lens module 32 into the facet of the optical fiber 320.

In an embodiment, the first light emitter 38 is a first edge-emitting laser diode, and the second light emitter 40 is a second edge-emitting laser diode. Regarding to several edge-emitting laser diodes with different wavelengths, in the embodiment, the edge-emitting laser diodes with wavelengths of 1310nm and 1550nm will be used.

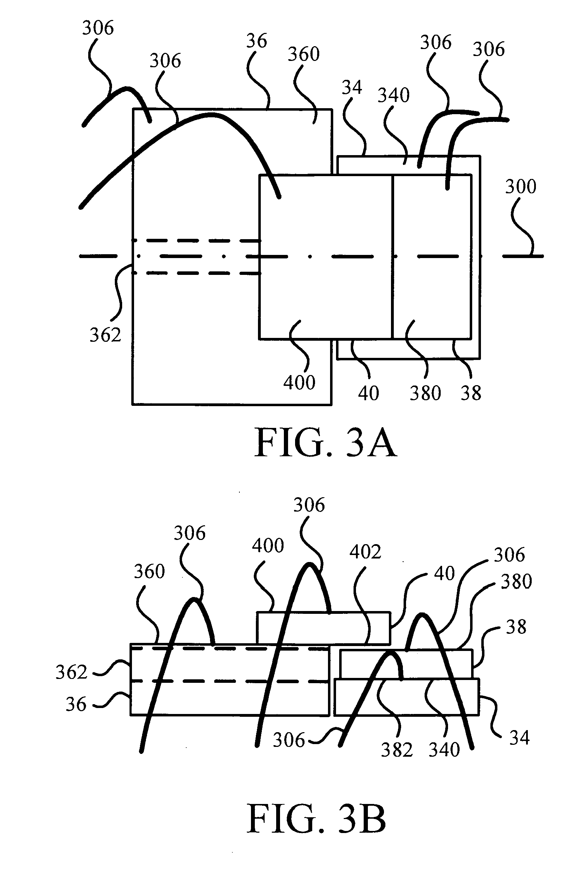

Please refer to FIG. 3A and FIG. 3B. FIG. 3A is a top view illustrating the relative positions of a first light emitter 38 and a second light emitter 40 in FIG. 2. FIG. 3B is a side view of FIG. 3A. As shown in FIG. 3A and FIG. 3B, in an embodiment, the second edge-emitting laser is partially suspended over the first edge-emitting laser diode without contacting each other.

In an embodiment, the base 30 has a plurality of bond pads (not shown in FIG. 3A and FIG. 3B), the first submount 34 has a first conductive surface 340 wire-bonded to one of the bond pads by a wire 306. Similarly, the second submount 36 has a second conductive surface 360 wire-bonded to one of the bond pads by a wire 306.

Also shown in FIG. 3A and FIG. 3B, respectively, the first edge-emitting laser diode has a first top electrode 380 wire-bonded to one of the bond pads by a wire 306 and a first bottom electrode 382 bonded on the first conductive surface 340 of the first submount 34, and the second edge-emitting laser diode has a second top electrode 400 wire-bonded to one of the bond pads by a wire 306 and a second bottom electrode 402 bonded on the second conductive surface 360 of the second submount 36.

Please refer to FIG. 2. In an embodiment, the optical communication device 3, according to the invention, further includes a first photodetector 44 and a second photodetector 46.

As shown in FIG. 2, the first photodetector 44 is mounted on the base 30 and optically coupled to the first edge-emitting laser diode. The first photodetector 44 is for the receiving of a first backward light emitted by the first edge-emitting laser diode, and the first backward light provides the compensation basis for emitting power of the first edge-emitting laser diode.

Also shown in FIG. 2, the second photodetector 46 is mounted on the base 30 and is optically coupled to the second edge-emitting laser diode. The second photodetector 46 is for the receiving of a second backward light emitted by the second edge-emitting laser diode, and the second backward light provides the compensation basis for emitting power of the second edge-emitting laser diode.

In an embodiment, a wavelength selective filter can be mounted on the base 30 and at the first reference axis 300 and between the first submount 34 and the first photodetector 44 for reflecting the second backward light to the second photodetector 46.

Please refer to FIG. 3A and FIG. 3B. To enable the first photodetector 44 to receive the first backward light emitted by the first edge-emitting laser diode, in an embodiment, the second submount 36 has an opening 362 formed through along the first reference axis 300 such that the first backward light is capable of passing through the opening 362 to the first photodetector 44.

In another embodiment, it is notable that the formats of the first forward light signal and the second forward light signal comply with the HDCP specification. And, in order to transmit data with Giga-bit/s range (i.e. uncompressed video streaming), the optical communication device of the invention is able to select optical fiber made of glass fiber to transmit the data.

Moreover, please refer to FIG. 2. In an embodiment, the base 30 thereon also defines a second reference axis 304, and the optical communication device 30 further includes a third photodetector 48 and a wavelength selective filter 50.

As shown in FIG. 2, the third photodetector 48 is mounted on the base 30 and at the second reference axis 304.

Also shown in FIG. 2, the wavelength selective filter 50 is mounted on the base 30 and at the first reference axis 300. The wavelength selective filter 50 is optically coupled to the optical fiber 320 and the third photodetector 48. The wavelength selective filter 50 is used to reflect a backward light signal transmitted over the optical fiber 320 to the third photodetector 48. The third photodetector 48 is for the receiving of the backward light signal. Wherein, the format of the backward light signal complies with the HDCP specification.

Furthermore, in another embodiment, the optical fiber 320 is capable of transmitting a plurality of backward light signals, each of which is then reflected to a respective photodetector by the dispositions of a plurality of wavelength selective filters and the plurality of photodetectors.

Please also refer to FIG. 2. In an embodiment, the optical communication device 3 further includes a second lens module 52. The second lens module 52 is mounted on the base 30 and at the second reference axis 304. The second lens module 52 is disposed between the wavelength selective filter 50 and the third photodetector 48, wherein the plurality of backward light signals are focused by the second lens module 52 to the third photodetector 48.

Compared with the prior art, the optical communication device, according to the invention, is able to let two, three, four or more adjacent light emitters transmit data over an optical fiber simultaneously. Accordingly, when the data required to be transmitted becomes larger, the problem of the insufficiency of transmitting data only by a light emitter will be solved.

With the example and explanations above, the features and spirits of the invention will be hopefully well described. Those skilled in the art will readily observe that numerous modifications and alterations of the device may be made while retaining the teaching of the invention. Accordingly, the above disclosure should be construed as limited only by the metes and bounds of the appended claims.

## Claims

1. An optical communication device, comprising:
a base;
an optical fiber module, mounted on the base, comprising an optical fiber;
a first submount, mounted on the base;
a second submount, mounted on the base, wherein the first submount is disposed between the second submount and the optical fiber module and adjacent to the second submount, the height of the second submount is higher than that of the first submount;
a first light emitter, mounted on the first submount and optically coupled to the optical fiber, for generating, by driven, a first forward light signal into a facet of the optical fiber, the first forward light signal being then transmitted over the optical fiber; and
a second light emitter, mounted on the second submount and optically coupled to the optical fiber, for generating, by driven, a second forward light signal into the facet of the optical fiber, the second forward light signal being then transmitted over the optical fiber.

2. The optical communication device of claim 1, wherein the base thereon defines a first reference axis, the first submount is at the first reference axis, and the second submount is at the first reference axis.

3. The optical communication device of claim 2, further comprising a first lens module, mounted on the base and at the first reference axis and disposed between the first submount and the optical fiber module, wherein the first forward light signal and the second forward light signal are focused by the first lens module into the facet of the optical fiber.

4. The optical communication device of claim 2, wherein the first light emitter is a first edge-emitting laser diode, and the second light emitter is a second edge-emitting laser diode.

5. The optical communication device of claim 4, wherein the second edge-emitting laser is partially suspended over the first edge-emitting laser diode without contacting each other.

6. The optical communication device of claim 4, wherein the base has a plurality of bond pads, the first submount has a first conductive surface wire-bonded to one of the bond pads, the second submount has a second conductive surface wire-bonded to one of the bond pads, the first edge-emitting laser diode has a first top electrode wire-bonded to one of the bond pads and a first bottom electrode bonded on the first conductive surface of the first submount, and the second edge-emitting laser diode has a second top electrode wire-bonded to one of the bond pads and a second bottom electrode bonded on the second conductive surface of the second submount.

7. The optical communication device of claim 4, further comprising:
a first photodetector, mounted on the base and optically coupled to the first edge-emitting laser diode, for receiving a first backward light emitted by the first edge-emitting laser diode, the first backward light providing the compensation basis for emitting power of the first edge-emitting laser diode; and
a second photodetector, mounted on the base and optically coupled to the second edge-emitting laser diode, for receiving a second backward light emitted by the second edge-emitting laser diode, the second backward light providing the compensation basis for emitting power of the second edge-emitting laser diode.

8. The optical communication device of claim 7, wherein the second submount has an opening formed along the first reference axis such that the first backward light can pass through the opening.

9. The optical communication device of claim 2, wherein the formats of the first forward light signal and the second forward light signal comply with the HDCP specification.

10. The optical communication device of claim 2, wherein the base thereon also defines a second reference axis, said optical communication device further comprises:
a third photodetector, mounted on the base and at the second reference axis; and
a wavelength selective filter, mounted on the base and at the first reference axis and optically coupled to the optical fiber and the third photodetector, respectively, for reflecting a backward light signal transmitted over the optical fiber to the third photodetector which receives the backward light signal.

11. The optical communication device of claim 10, further comprising a second lens module, mounted on the base and at the second reference axis and disposed between the wavelength selective filter and the third photodetector, wherein the backward light signal is focused by the second lens module to the third photodetector.
